Europäisches Patentamt

(19) European Patent Office

Office européen des brevets

(11) Publication number: **0 206 055**
**B1**

(12) **EUROPEAN PATENT SPECIFICATION**

(45) Date of publication of the patent specification:
26.09.90

(51) Int. Cl.⁵: **C04B 41/91, H01L 21/31**

(21) Application number: 86107740.2

(22) Date of filing: 06.06.86

(54) A reactive ion etching process.

(30) Priority: 20.06.85 US 747156

(43) Date of publication of application:
30.12.86 Bulletin 86/52

(45) Publication of the grant of the patent:
26.09.90 Bulletin 90/39

(84) Designated Contracting States:
DE FR GB IT

(56) References cited:
EP-A- 0 084 635

EXTENDED ABSTRACTS, vol. 77-2, October 1977,
pages 400,401, abstract no. 145, Princeton, New Jersey,
US; E.C.D. DARWALL: "The control of plasma etched
edge profiles"
EXTENDED ABSTRACTS, vol 82-1, May 1982,
pages 339-340, abstract no. 211, Pennington, New
Jersey, US; E.C. WHITCOMB: "Selective, anisotropic
etching of SIO2 and PSG in a CHF3/SF6, RIE plasma"
PATENT ABSTRACTS OF JAPAN, vol. 7, no. 204 (E-197)
[1349], 9th September 1983; & JP-A-58 101 428

(73) Proprietor: International Business Machines
Corporation, Old Orchard Road, Armonk, N.Y. 10504(US)

(72) Inventor: Bianchi, Jacqueline Kay, 12 Cheltenham Way,
San Jose California 95139(US)
Inventor: Gdula, Robert Anthony, 140 Cleland Avenue,
Los Gatos California 95030(US)
Inventor: Lange, Dennis John, 1097 Cannon Road,
Aromas California 95004(US)

(74) Representative: Burt, Roger James, Dr., IBM United
Kingdom Limited Intellectual Property Department
Hursley Park, Winchester Hampshire SO21 2JN(GB)

**Description**

This invention relates to a reactive ion etching process for etching a ceramic partially masked with a photoresist.

The use of $SF_6$ as an etchant gas is disclosed in US-A-4,330,384. US-A-4,447,290 describes the use of $SF_6$ with the addition of Freon 12 as an indicator gas for the plasma etching of polysilicon.

In fabricating integrated circuits, it is sometimes desirable to etch deep pockets or holes (10 to 20 μm deep) into ceramics which are difficult or impossible to etch by conventional wet chemical means. Such etching may be accomplished by subjecting the ceramic which is partially masked by an organic photoresist to reactive ion etching. However, the etch rates using conventional RIE processes are typically very slow.

Ceramics of interest can be rapidly etched by utilising a high power density (>1 watt/cm$^2$) $SF_6$ RIE process, but in this process the photoresist mask is eroded much more rapidly than the ceramic is etched. In this case the mask does not endure long enough to achieve the required etch depth in the ceramic. In other words, the ratio of the etch rate of the photoresist mask to the etch rate of the ceramic is not low enough. In fact, it is so unfavourable that the mask erodes 8 times faster than the ceramic etches.

The present invention provides a solution to the problem of photoresist mask degradation during reactive ion etching processes using $SF_6$ as the etchant gas. By means of the present invention, the ratio of the etch rate of the photoresist to the etch rate of a ceramic has been decreased to below 5 which is satisfactory.

There is disclosed in Extended Abstracts, Vol. 77-2, October 1977, pages 400, 401, abstract no. 145, a reactive ion etching process for etching silicon dioxide which uses an etch gas consisting of Ar and $CHF_3$.

A reactive ion etching process for etching a substrate partially masked by a photoresist using an etch gas comprising $SF_6$ and a noble gas, is characterised according to the invention, by the etch gas further comprising 10 to 13 per cent by volume of a gaseous compound containing fluorine and carbon, and by the substrate being a ceramic substrate.

Prior to the present invention, $SF_6$ had not been a satisfactory etch gas when ceramic and photoresist were being simultaneously etched. Even though $SF_6$ makes it possible to achieve faster rates than previously obtained, it has the disadvantage of attacking the organic photoresist and causing degradation. For example, when a resist mask comprising poly(methylmethacrylate) was etched with 100% $SF_6$, areas where resist bridged from row to row in the carrier were destroyed. Attack of the protective surface also occurred by etchant penetration through the resist, or percolation under the resist edges. Dilution of $SF_6$ with an inert gas, such as argon or helium, decreases the degradation of the resist somewhat; however, at best, the results are marginal. To achieve the desired depth of etch, this etch rate ratio must be 5 or less.

It has now been found that when a small amount of a gaseous compound containing carbon and fluorine is added to the etch gas, both the etch rate for photoresist and for ceramic decrease. The etch rate for photoresist, however, decreased more than that for ceramic. A 13% addition of a gaseous compound containing carbon and fluorine depressed the reactive ion etch rate for photoresist by 25%, while the etch rate for ceramic was depressed by only 5%.

Satisfactory carbon and fluorine containing gases include $CF_4$, $C_{12}F_6$ and $CHF_3$. The most preferred gas is $CHF_3$.

Experimental results using various etch gas mixtures are shown in Tables 1 and 2 below.

2

## TABLE 1

SF$_6$/ARGON GAS MIXTURES USED IN REACTIVE ION ETCH TOOL

| Etch Gas Mixture (vol percents) | Ceramic RIE Rate (µm/hr) | Photoresist RIE Rate (µm/hr) | Photoresist/ Ceramic Etch Rate Ratio |
|---|---|---|---|
| 100% SF$_6$ | 3.4 | > 20 | > 6 |
| 75% SF$_6$ 25% Ar | 3.1 | > 20 | > 6 |
| 50% SF$_6$ 50% Ar | 3.1 | > 20 | > 6 |
| 39% SF$_6$ 61% Ar | 3.0 | ~ 18 | ~ 6 |
| 19% SF$_6$ 81% Ar | 1.2 | ~ 12 | ~ 10 |

## TABLE 2

### SF$_6$/HELIUM/CARBON GAS MIXTURES USED IN REACTIVE ION ETCH TOOL

| Etch Gas Composition (vol percents) | | | Ceramic RIE Rate (μm/hr) | Photoresist RIE Rate (μm/hr) | Photoresist/ Ceramic Etch Ratio |
|---|---|---|---|---|---|
| 50.0% SF$_6$ | 50.0% He | | 4.04 | 23.0 | 5.9 |
| .7% SF$_6$ | 46.7% He | 26.6% CF$_4$ | 3.13 | 14.7 | 4.7 |
| 0% SF$_6$ | 0% He | 100.0% CF$_4$ | 1.90 | 7.6 | 4.0 |
| 44.1% SF$_6$ | 44.1% He | 11.8% C$_2$F$_6$ | 3.81 | 21.0 | 5.5 |
| 38.0% SF$_6$ | 38.0% He | 24.0% C$_2$F$_6$ | 3.48 | 17.7 | 5.1 |
| 26.7% SF$_6$ | 46.7% He | 26.7% C$_2$F$_6$ | 3.40 | 17.1 | 5.0 |
| 40.0% SF$_6$ | 46.7% He | 13.3% CHF$_3$ | 3.82 | 17.9 | 4.7 |
| 26.7% SF$_6$ | 46.7% He | 26.7% CHF$_3$ | 3.08 | 11.3 | 3.7 |
| 45.0% SF$_6$ | 45.0% He | 10.0 CHF$_3$ | 3.88 | 18.2 | 4.7 |

Our experiments indicate the optimum etch gas to be SF$_6$ with an approximately equal amount of a noble gas, and a small percentage, say about 10%, of a carbon-containing gas, preferably CHF$_3$. The best etch gas composition is 45% SF$_6$, 45% He and 10% CHF$_3$. Gases are mixed by mass flow controllers; therefore the percentages are volume percentages.

### Claims

1. A reactive ion etching process for etching a substrate partially masked by a photoresist, using an etch gas comprising SF$_6$ and a noble gas, the process being characterised by the etch gas further comprising 10 to 13 per cent by volume of a gaseous compound containing fluorine and carbon.

2. A process as claimed in claim 1, wherein about 10% of the etch gas is comprised by the gaseous compound containing fluorine and carbon.

3. A process as claimed in claim 1 or claim 2, wherein the gaseous compound is CHF$_3$.

4. A process as claimed in claim 3, wherein the etch gas is 45% SF$_6$, 45% He, and 10% CHF$_3$, by volume.

### Patentansprüche

1. Reaktives Ionenätzungsverfahren zum Ätzen eines teilweise durch ein photoresistentes Material verdeckten Substrats, mit Verwendung eines Ätzgases, das SF$_6$ und ein Edelgas enthält, Verfahren dadurch gekennzeichnet, daß das Ätzgas außerdem 10 bis 13 Volumenprozent einer gasförmigen Verbindung mit Fluorin und Kohlenstoff enthält.

2. Verfahren gemäß Anspruch 1, in dem ca. 10% des Ätzgases aus der gasförmigen Verbindung mit Fluorin und Kohlenstoff bestehen.

3. Verfahren gemäß Anspruch 1 oder Anspruch 2, in dem die gasförmige Verbindung $CHF_3$ ist.

4. Verfahren gemäß Anspruch 3, in dem das Ätzgas aus 45 Volumen-% $SF_6$, 45 Volumen-% He und 10 Volumen-% $CHF_3$ besteht.

## Revendications

1. Procédé de gravure ionique réactive pour graver un substrat partiellement masqué par un produit photosensible, utilisant un gaz d'attaque comprenant $SF_6$ et un gaz noble, ce procédé étant caractérisé en ce que le gaz d'attaque comprend en outre 10 à 13 pour cent en volume d'un composé gazeux contenant du fluor et du carbone.

2. Procédé selon la revendication 1, dans lequel environ 10% du gaz d'attaque est constitué du composé gazeux contenant du fluor et du carbone.

3. Procédé selon la revendication 1 ou 2, dans lequel le composé gazeux est $CHF_3$.

4. Procédé selon la revendication 3, dans lequel le gaz de gravure comprend 45% de $SF_6$, 45% de He, et 10% de $CHF_3$, en volume.